# EUROPEAN PATENT APPLICATION

(11) **EP 4 790 014 A1**
(43) Date of publication of application: **12.08.2026**
(21) Application number: 25156434.0
(22) Date of filing: 07.02.2025
(51) Int. Cl.: B81C 1/00, B81C 99/00

(54) **MANUFACTURING, TESTING AND CALIBRATION OF DEVICES USING A LID FRAME**

(71) Applicant: Murata Manufacturing Co., Ltd., Nagaokakyo-shi, Kyoto 617-8555 (JP)
(72) Inventor: KAIJA, Kimmo, 02660 Espoo (FI)
(74) Representative: Boco IP Oy Ab

(57) **Abstract**

The disclosure relates to a aspects of a method for manufacturing electronic and/or microelectromechanical system, MEMS, devices using a lid frame that carries a plurality of such devices. Use of the lid frame enables performing manufacturing steps as well as testing and/or calibration of devices packaged into individually produced housings with manufacturing, testing and calibration equipment that is designed to handle lead frames.

## Description

### FIELD OF THE DISCLOSURE

The present disclosure relates to electronic and/or microelectromechanical (MEMS) device manufacturing, and particularly to arrangement for facilitating testing and/or calibration of electronic and/or microelectromechanical (MEMS) devices. More particularly, the present disclosure concerns a method and a lid frame that enables testing and/or calibrating electronic and/or MEMS devices packaged in a closed housing.

### BACKGROUND OF THE DISCLOSURE

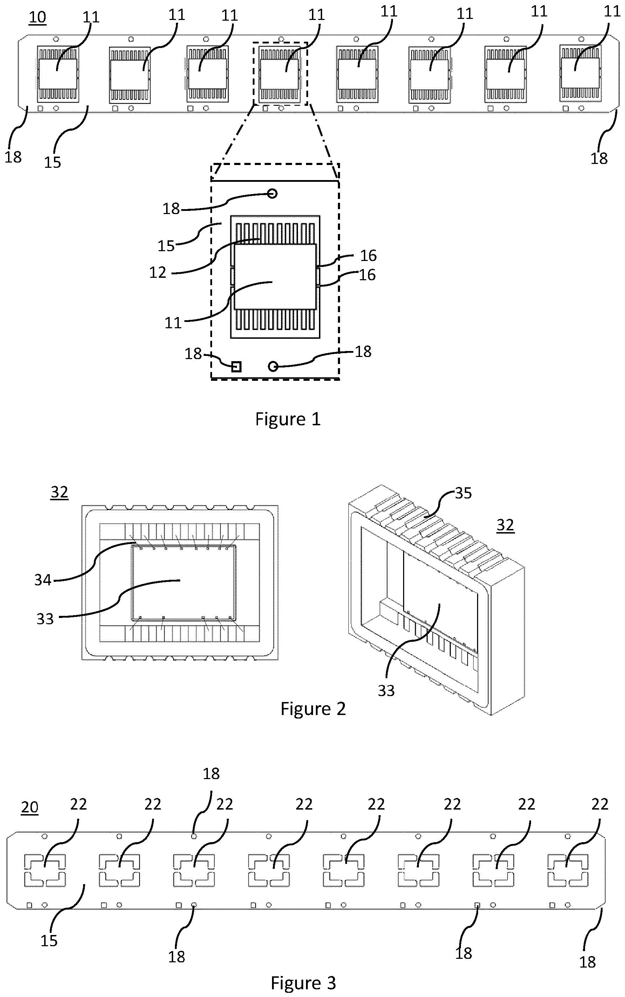

Figure 1 illustrates an exemplary lead frame 10 as known in the art. The marked portion is enlarged to improve clarity. A lead frame 10 is a thin, patterned layer of metal that is commonly utilized in a semiconductor device manufacturing process. In a typical application, the lead frame 10 provides a die pad 11 for attaching one or more integrated circuit components thereon and leads 12 for electrical connections between the integrated circuit component and the outside the device package.

A plurality of die pads 11 is arranged at predefined, typically regular intervals, along the longitudinal dimension of the elongated lead frame 10. Each die pad 11 is associated with leads 12 and coupled to a frame portion 15 of the lead frame 10 with coupling portions 16 that are designed to enable separating readily assembled and possibly tested devices from the lead frame 10. Lead frames 10 are provided in various forms. The frame portion 15 is designed to enable automatic handling of lead frames 10 in a manufacturing process, and the manufacturing equipment is typically designed to handle certain type or types of lead frames. Design of the lead frames vary. Thus, the shape of the exemplary lead frame or its frame portion 15 are not limiting.

Lead frames 10 are typically shaped into elongated strips which can be handled by manufacturing machines during a manufacturing process. The strip-shaped lead frame 10 carries several device packages. Designs of lead frames 10 depend on applied manufacturing processes and equipment, as well as types of integrated circuits.

A typical semiconductor device manufacturing line comprises various manufacturing process equipment configured to handle one or more predefined types of lead frames instead of handling individual housings and/or devices. Testing and/or calibration of devices may be performed before the readily packaged device is cut out from the lead frame. For facilitating accurate alignment of lead frames 10, lead frames 10 are designed to be handled by a particular manufacturing equipment. For ensuring accurate handling, lead frames 10 have a predefined shape, and may be provided with frame alignment features 18, such as holes, shaped outer edges, cutoffs and/or recessions at predefined positions on a frame portion of the lead frame 10.

Some types of electronic and/or MEMS devices are preferably packaged in a type of package that is not provided on lead frames. For example, it may be desirable to use a prefabricated or pre-moulded housing, that is provided with a cavity into which the electronic and/or MEMS components are disposed. Such prefabricated or pre-moulded housings may be received from a manufacturer as individual packages, not attached to a lead frame. Prefabricated or pre-moulded housings may be manufactured from plastic, or ceramic. A pre-moulded housing without a cavity or with a shallow cavity is also applicable. A shallow cavity refers to situation where depth of the cavity is less than thickness of components placed within the cavity.

Figure 2 illustrates a top view and an isometric view of an exemplary housing 32 with a cavity. One or more components 33, for example electronic components and/or MEMS components, are placed in the cavity of the housing 32 and wire bonded by bond wires 34 to leads 35 for providing electrical connections between the one or more components 33 inside the housing 32 and the outside of the housing 32.

For example, ceramic housing with a cavity is typically used for packaging a MEMS device. Such ceramic housings are pre-manufactured and provided typically as individual housings, not attached to a lead frame. Ceramic housings may be used for example to improve thermal insulation, sound insulation and thermal accumulation properties. Ceramic housings are also known to be more durable and reliable in comparison to for example plastic packaging, and thus more suitable for harsh environments.

MEMS devices often need a hermetic or near-hermetic packaging, which may be filled with gas or may have reduced pressure inside the packaging to enable and facilitate desired movement of micromechanical elements of the MEMS device. Such hermetic or near-hermetic packaging may require a ceramic housing that has a cavity into which the electronic and/or MEMS components are placed into. A near-hermetic packaging may also be achieved using a pre-moulded plastic housing.

An individual housing may as such comprise all required electrical connections, which may be manufactured in any known manner.

Existing testing and/or calibration equipment used in a manufacturing process may be designed to be used with lead frames, which facilitates for example simultaneously testing and/or calibrating a plurality of readily packaged components. If packaged components are individual, in other words not on a lead frame, the existing testing and/or calibration equipment are not useful for such individual components. This would require a major investment to new type of testing and/or calibration equipment in the production line. Furthermore, handling of individual housings may slow down the manufacturing process and increase number of errors in the process, which may lead to reducing yield of the process, in other words adding share of non-acceptable components.

### BRIEF DESCRIPTION OF THE DISCLOSURE

An object of the present disclosure is to provide apparatus and method so as to solve the above problem.

The object of the disclosure is achieved by a method and an arrangement which are characterized by what is stated in the independent claims. Some embodiments of the disclosure are disclosed in the dependent claims.

The disclosure is based on the idea of providing a lid frame that comprises a plurality of lids, each designed to close a component housing. A component housing is referred herein in short as housing. Previously separated, individual housings with components installed therein are attached to the lid frame for testing and/or calibration purposes.

According to an aspect, a method for manufacturing a plurality of electronic and/or microelectromechanical system, MEMS, devices is provided. The method comprises i) providing a lid frame comprising a frame portion and a plurality of lids. The plurality of lids is placed in the lid frame in a row at predefined intervals along the longitudinal dimension of the lid frame. The method comprises ii) placing a plurality of housings on the lid frame, each housing comprising one or more electronic and/or MEMS components and electrical connections thereof, iii) adhering each of the plurality of lids to the respective housing to enclose electronic and/or MEMS components of the electronic and/or MEMS device in an enclosure formed by the housing and the lid, and iv) testing and/or calibrating the plurality of electronic and/or MEMS devices while adhered to the lid frame by means of an apparatus designed to perform testing and/or calibration of devices attached to a lead frame having a frame portion with dimensions similar to dimensions of the frame portion of the lid frame. The method comprises, after said testing and/or calibrating, detaching the plurality of electronic and/or MEMS devices from the lid frame by any one of: cutting, punching, and laser detachment such that each lid remains adhered to the respective housing.

According to some embodiments, the method comprises, prior to placing the plurality of housings on the lid frame, placing the plurality of housings on a tray. The plurality of housings is placed on a plurality of depressions of the tray. The plurality of depressions is arranged into a row along the longitudinal dimension of the tray at the same predefined intervals as the plurality of lids in the lid frame. The method then comprises placing the plurality of housings on the lid frame by placing the lid frame on the plurality of housings placed on the tray, thereby covering each one of the plurality housings by a collocated one of the plurality of lids before said adhering each one of the plurality of lids to the respective housing.

According to some embodiments, the step of placing the plurality of housing on the tray further comprises forcing each housing to be aligned with a respective tray wall by means of at least one spring arrangement comprised in or attached to the tray.

According to some embodiments, the method comprises placing the plurality of housings on the lid frame by means of a pick and place equipment prior to adhering the respective housing to the respective one of the plurality of lids.

According to some embodiments, the method comprises providing each of the lids of the lead frame and/or the housing with at least one lid alignment feature and guiding each housing to a correct position with respect to the respective lid in the lead frame by means of the at respective least one lid alignment feature. The at least one lid alignment feature is configured to facilitate correct alignment between the housing and the respective lid.

According to some embodiments, the lid alignment feature comprises at least two bent edges of the lid, and the method comprises prior to placing the plurality of housings on the lid frame, bending at least some edges of the plurality of lids to facilitate alignment of the housing with the respective lid.

According to some embodiments, the lid alignment feature comprises one or more of the following: a depression in the housing and a matching shape of the lid, a depression in the housing and a matching coupling portion of the lid frame, a hole in the lid frame and a matching pin in the housing.

According to some embodiments, the method comprises attaching the lid to the respective housing by any one of: an adhesive, a partial seam weld, spot welding, full seam welding, and full seam soldering.

According to some embodiments, the method comprises attaching the lid to the housing using full seam welding. The method comprises, prior to placing the plurality of housings on the lid frame, bending a plurality of coupling portions of the lid frame coupling the plurality of lids to the frame portion of the lid frame, to cause an offset between a plane defined by the plurality of lids and a plane defined by the frame portion, and performing the full seam welding between each one of the plurality of housings and the respective lid by means of wheel electrodes.

According to some embodiments, the upper face of each of the plurality of housings is provided with a kovar ring to facilitate hermetic sealing between the housing and the respective lid, and the method comprises attaching the lid to the housing using full seam soldering or full seam welding.

According to some embodiments, the method further comprises, prior to placing the plurality of housings on the lid frame, applying one of an adhesive and a solder on each lid of the lid frame and/or on the upper face of the housing.

According to another aspect, a lid frame is provided, comprising a frame portion and plurality of lids arranged in a row at predefined intervals along the longitudinal dimension of the lid frame. The lid frame is configured to be used in the method according to the above aspect and embodiments.

According to another aspect, a device testing and/or calibration equipment is provided, configured to test and/or calibrate electronic and/or MEMS devices attached to a lid frame.

According to an aspect, an elongated tray is provided. The elongated tray comprises a plurality of depressions arranged into a row along the longitudinal dimension of the elongated tray at the same predefined intervals as the plurality of lids in the lid frame. The plurality of depressions is configured to receive a housing comprising one or more electronic and/or MEMS components and electrical connections thereof. The elongated tray is configured to be used in the method according to any one of the applicable aspects and embodiment involving use of the elongated tray.

An advantage of the disclosure is that the same testing and/or calibration equipment can be used at the manufacturing facility that is used for handling, testing and/or calibrating components in a lead frame. This saves costs in form of investment to manufacturing equipment, in particular testing and/or calibration equipment. Handling of frame is easier than handling individual components.

### BRIEF DESCRIPTION OF THE DRAWINGS

In the following the disclosure will be described in greater detail by means of preferred embodiments with reference to the accompanying drawings, in which:
Figure 1 illustrates a lead frame;
Figure 2 illustrates a housing;
Figure 3 illustrates a lid frame;
Figure 4 illustrates a tray;
Figures 5A, 5B and 5C illustrate a lid frame with housings;
Figures 6A, 6B and 6C illustrate separation of devices from the lid frame and a device according to some embodiments;
Figures 7A and 7B illustrate a device according to some embodiments;
Figure 8 illustrates misalignment between housings and lids;
Figure 9 illustrates use of spring arrangement on the tray;
Figures 10A and 10B illustrate use of adhesive on lid area;
Figure 11 illustrates bending of lid edges as a lid alignment feature;
Figures 12A, 12B and 12C illustrate lid alignment features;
Figure 13 illustrates steps of a method;
Figure 14 illustrates steps of a method.

### DETAILED DESCRIPTION OF THE DISCLOSURE

The disclosure relates to a manufacturing process of electronic and microelectromechanical (MEMS) devices.

In this context, term lid frame refers to a thin, patterned layer of metal comprising a plurality of lids. The lid frame is shaped into an elongated strip that can be handled by lead frame handling -capable equipment during a manufacturing process. The lid frame is configured to carry a plurality of devices, each comprising one or more components packaged in a housing. Details of the design of the lid frame depends on applied manufacturing processes and equipment, as well as types of electronic and MEMS components packaged in the housing that is to be attached to the lid frame.

In this context, a component refers to a chip, in other words a semiconductor die configured to perform at least one function. Components may be electronic, or they may comprise MEMS circuitry, in which case there may be both micromechanical and electronic functions.

In this context, a housing is configured to receive one or more components and providing electrical connections between components inside the housing and outside of the housing. The housing may comprise a cavity for receiving components.

In this context, a device refers to an electronic device or a MEMS device, which comprises components packaged in a housing that is closed by a lid.

Figure 3 illustrates a lid frame 20 designed to be handled by the same manufacturing equipment as the lead frame 10 of the Figure 1 at least for performing testing and/or calibration of devices. The frame portion 15 has the same shape and size and it shares other design details, such as frame alignment features 18, that facilitate automated handling. However, lead 12 and die pad 11 comprising portions of the lead frame 10 are replaced with an equal number of lids 22 attached to the frame portion 15 by coupling portions 16 designed to be cut in the manufacturing process for separating each lid 22 from the lid frame 20. The lid frame 20 may be manufactured, just as a lead frame, by cutting a thin, flat sheet of material into the desired shape. Manufacturing process may further comprise steps for bending predefined portions of the lid frame 20.

Various materials can be used for the lid frame 20 and lids 22 thereof, based on requirements of the components and the housing for which the lid is to be installed. For example, the lid frame 20 and lids 22 may be manufactured out of stainless steel, which is compatible for seam welding and laser welding. Copper, such as Cu194 can be used with adhesive attachment and solder attachment. Thickness of the lid 22 is preferably between 0.15 mm and 0.35 mm, more preferably between 0.20 and 0.30 mm, most preferably about 0.25 mm. In addition to design of the lid frame 20 as such, main criteria for determining optimal thickness of the lid frame 20 and the lid 22 are rigidity and cost. The lid frame 20 should be rigid enough to be handled, when housings 32 are attached thereto, and cost of the lid frame 20 depends on thickness and thus amount of material needed.

One method for disposing a plurality of housings 32 on respective lids 22 of a lid frame 20 is to use a so-called pick and place device, as known in the art, which picks individual housings 32 one by one and places each house at the respective lid 22. Alternatively, a tray may be used on which the individual housings are disposed and the lid frame 20 is placed on top of the housings 32.

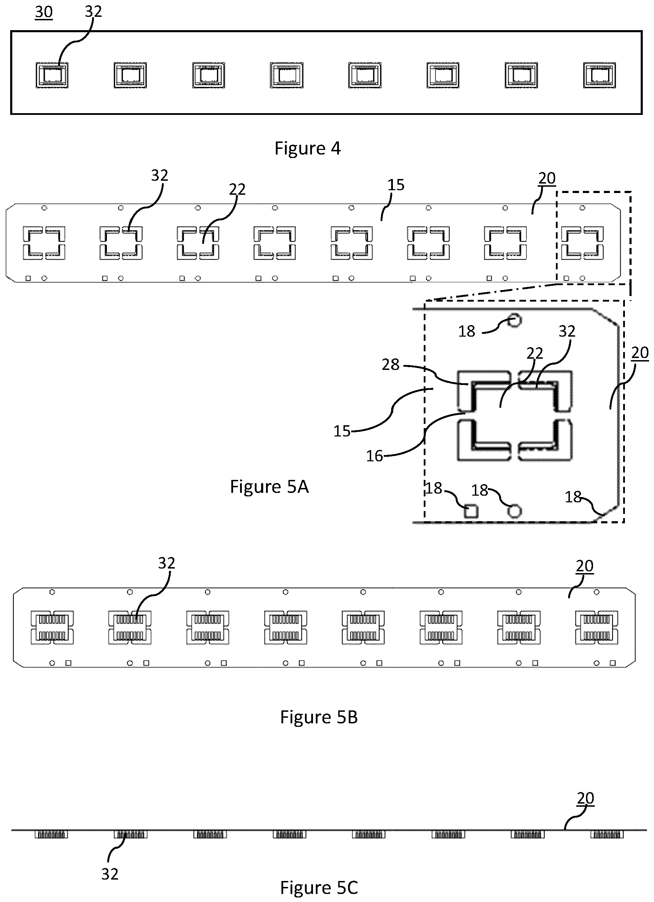

Figure 4 illustrates a tray 30 with a plurality of housings 32 arranged thereon. Positions of the housings 32 on the tray 30 are preferably determined by shallow depressions (not shown) in the housing, in which the housings 32 are fitted. In this context, a shallow depression means that depth of the depression is not greater to the height of the housing 32 for which the depression is designed for, so that upper face of the housing 32 remains at or above the upper face of the tray 30.

Each housing 32 comprises one or more components 33 of an electronic device or a MEMS device. Components 33 of a MEMS device may comprise MEMS components as well as electronic components, such as microprocessors, application specific integrated circuits and/or any other circuitry needed for operation of the electronic or the MEMS device. An exemplary housing with a component 33 in a cavity was discussed above in connection with the Figure 2. There may be more than one component 33 disposed in the cavity of the housing 32.

A pick and place device may be used for placing individual housings 32 on the tray.

Each lid 22 on the lid frame 20 is attached to the respective housing. Attaching the lid to the respective housing by any one of adhesive, partial seam weld, spot welding, full seam welding, and full seam soldering.

If full seam welding is used for adhering the lid and the respective housing, there needs to be an offset between the plurality of lids and the frame portion of the lid frame. To create such offset, coupling portions of the lid frame may be bent to cause the desired offset between a plane defined by the frame portion of the lid frame and a plane defined by the plurality of lids of the lid frame. Wheel electrodes can be used to perform full seam welding between each one of the plurality of housings and the respective lid.

Figures 5A, 5B and 5C illustrate the lid frame 20 with the plurality of housings 32 attached thereto. Figure 5A illustrates a view at the lid frame 20 side. In this exemplary design, outer edges of housings 32 extend beyond the respective lid 22 to avoid any unwanted electrical contact with the lid. Thus, outer edges of the housing 32 can be seen through openings 28 in the lid frame 20 surrounding the lid 22, as can be seen in the enlarged portion of the figure 5A. Like in a lead frame, the lid 22 is coupled to the frame portion 15 of the lid frame 20 by a plurality of coupling portions 16 formed between openings 28. The frame portion 15 of the lid frame 20 preferably shares the same frame alignment features 18 with a respective lead frame design so that the lid frame 20 can be handled with existing manufacturing line equipment that is designed to handle lead frames.

Figure 5B illustrates the same lid frame 20 with the plurality of housings 32 attached thereto when viewed at the housing side.

Figure 5C illustrates a side view of the same lid frame 20 with the plurality of housings 32 attached thereto. In this exemplary embodiment, the lid frame 20 is a flat sheet from which the housings 32 protrude. According to some embodiments, the lids 22 of the lid frame are bent such that the lids are parallel to the frame portion 15 of the lid frame but at a non-zero distance from the flat plane determined by the frame portion 15.

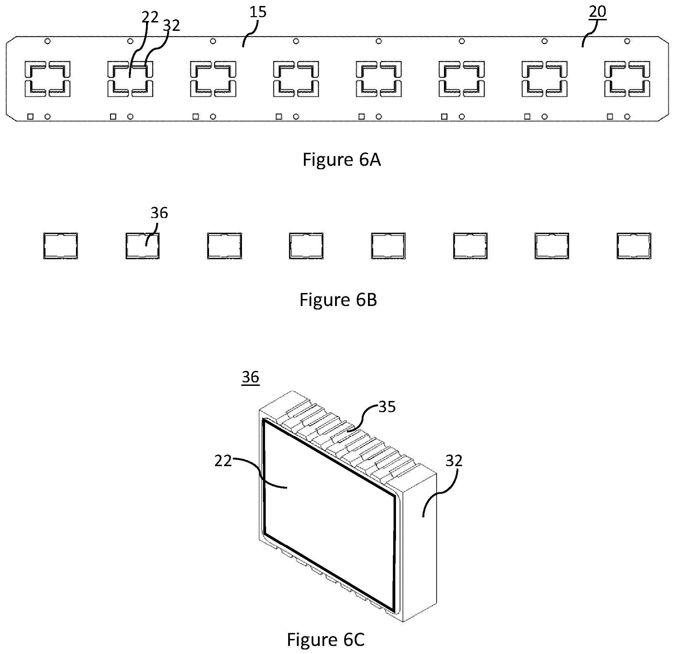

Figures 6A, 6B and 6C illustrate detaching tested and/or calibrated devices 36 from the lid frame 20.

Figure 6A illustrates the lid frame 20 with attached housings 32. Detaching of devices may be performed in various way. Devices 36 may be electronic or MEMS devices. Detaching is implemented by cutting the coupling portions 16 so that lids 22 are separated from the frame portion 15 of the lid frame 20. Exemplary detaching methods comprise cutting, punching, and laser detachment. The lid 22 remains adhered to the respective housing 32 after detaching the frame portion 15. Devices 36 comprise the housing 32, the lid 22 and the electronic and/or MEMS components 33 disposed within the lid-covered housing 32. The electronic and/or MEMS components 33 are electrically coupled to leads provided in the housing 32 and if there are more than one components 33 included in the device 36, they may also be electrically coupled with each other according to design of components 33. Purpose of the lid 22 is to enclose the circuitry inside the housing. In some types of MEMS device may need to be enclosed hermetically inside the housing 32. The lid 22 forms a part of such hermetic enclosure together with the housing 32.

Figure 6C illustrates an isometric view of a device 36 after it has been separated from the lid frame 20. One or more components are enclosed within an enclosure formed by the housing 32 and the lid 22. Leads 35 provide electrical connections to the enclosed components.

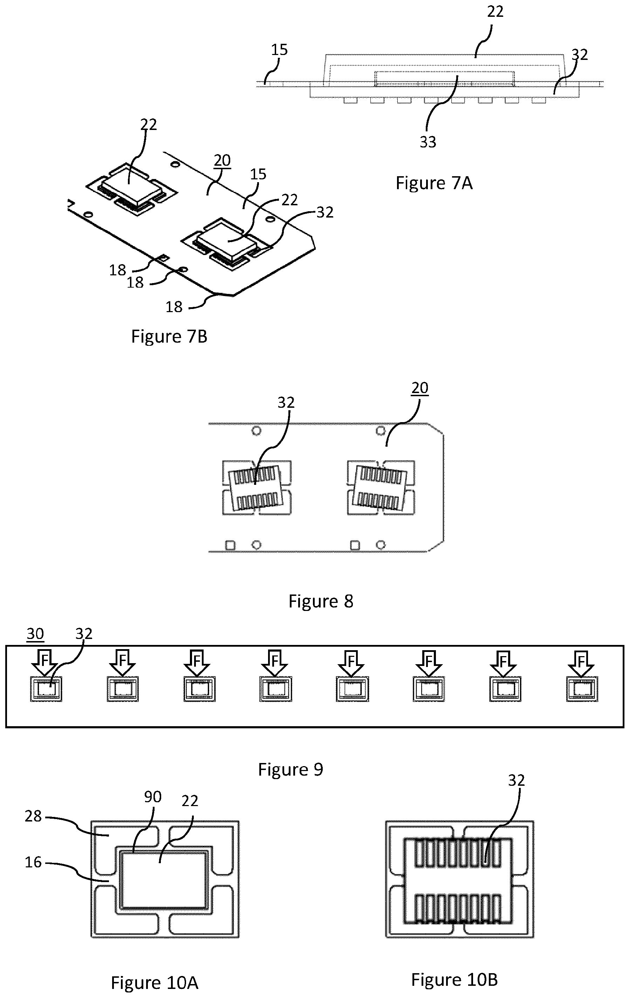

Figures 7A and 7B illustrate another exemplary embodiment. Figure 7A illustrates schematically a cross section of a housing attached to the lid frame 20, and Figure 7B illustrates an isometric view of a portion of a lid frame 20 to which housings 32 have been attached to. A cavity is not necessary in the housing 32. According to some embodiments, depth of the cavity in the housing 32 is less than height of one or more components 33 disposed within the cavity or there is no cavity in the housing 32 at all. When there is no cavity or the cavity of the housing 32 is shallow in comparison to height of one or components 33, at portion of the components and/or their bodings may protrude above the upper face of the housing. Even if components 33 are not fully within a cavity of the housing 32, the housing 32 can be closed by a lid 22 of the lid frame 20 when the lid 22 is formed as a bulging cap as illustrated in figures 7A and 7B. The lid 22 thus leaves sufficient room between the components 33 and the lid 22 when the lid 22 is attached to the housing 32 at its outer edges. For manufacturing such devices, lids 22 in the lid frame 20 are bent to the desired three-dimensional shape.

One possible problem in the manufacturing process is that a housing 32 may be misaligned with respect to the lid 22 in the lid frame 20. This problem is illustrated in the Figure 8. In this example, a so called cross-axis error occurs, in which the longitudinal axis of the housing 32 is not aligned with the longitudinal axis of the lid 22 and/or the longitudinal axis of the lid frame 20. Misalignment may cause a situation in which the lid 22 does not fully cover the cavity in the housing 32, which will eventually cause rejection of the device and thus reduction of yield of the manufacturing process. Another problem is that testing and/or calibration of the device may fail for example because probes of a testing and/or calibration apparatus does not meet leads of the housing. There are several alternatives to avoid such misalignment problems.

Figure 9 illustrates a solution in which the tray is provided with a spring arrangement designed to subject each housing to a spring force F that causes the housing 32 to sit properly aligned in the respective depression provided on the tray. The spring arrangement may be comprised in the tray or the spring arrangement may be permanently or removably attached to the tray. When the alignment of housings is ensured by means of the tray, the lid frame can be attached on the housings that are reliably properly aligned with the tray 30.

Figures 10A and 10B illustrate attachment of the housing 32 to a lid 22 using an adhesive 90. Figure 10A illustrates pre-application of adhesive 90 on the lid 22, and figure 10B illustrates a housing 32 placed on the lid 22, attached thereon by means of the adhesive 90. Adhesive 90 may be screen printed to generate a precise pattern. If adhesive attachment is used, the pre-applied adhesive is preferably b-staged. As known in the art, b-staging refers to bringing the adhesive to an intermediate stage between application and curing. B-staging means removing majority of solvent from the adhesive by means of heat or UV light, and the b-staged adhesive can be held in this stage for a longer period of time without sacrificing adherence performance. B-staged adhesive facilitates temporary attachment between the housing 32 and the lid 22 before the adhesive is cured. Housings 32 may be placed on the adhesive either using a tray or using a pick and place equipment that places individual housings on the respective lids 22 of the lid frame 20.

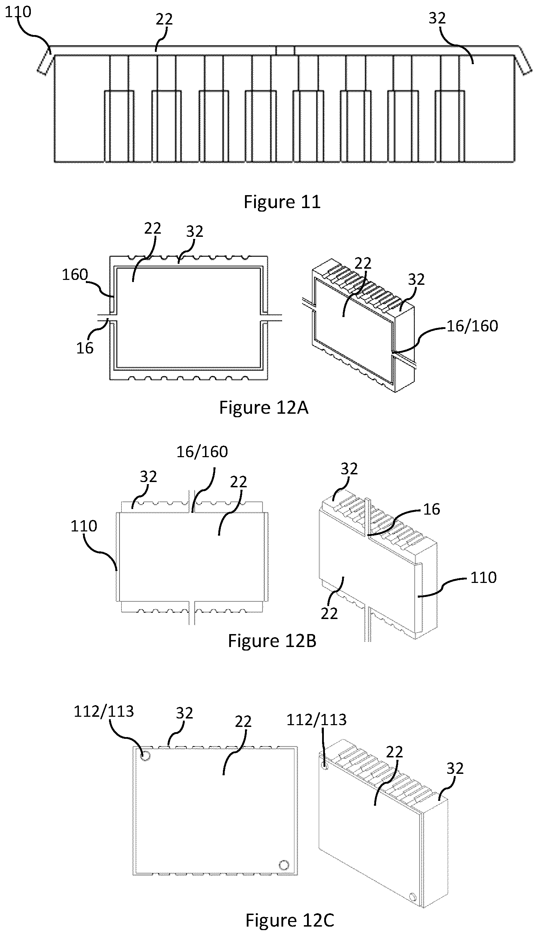

Figure 11 illustrates one solution for improving accuracy of alignment of the housing 32 with the respective lid 22. Each lid 22 of the lid frame may have at least some bent edges 110, which guide each respective housing 32 to a proper position and alignment with respect to the respective lid 22 when the lid frame 20 is placed on top of the tray and the housings residing on the tray, or when the housing 32 is placed at the appropriate position on the lid frame 20. Such arrangement with bent edges of lids may be applied as the only alignment improving solution, or for example together with the spring-assisted alignment solution provided in the tray.

A further possibility to improve accuracy of alignment between the lid and the housing is to use additional lid features that match which respective lid alignment features in the housing 32. Non-limiting examples of lid alignment features are illustrated in figures 12A, 12B and 12C.

Figure 12A illustrates a lid alignment feature in the housing 32 and the lid frame 20, where the upper face of the housing 32 is provided with recessed portion 160 into which the lid 22 is fitted. In this example, the lid 22 and the lid frame 20 is flat, and the recessed portion is further formed to fit coupling portions 16 therein.

Figure 12B illustrates using bent edges 110 of the lid 22 as the lid alignment feature, to improve accuracy of mutual alignment between the housing 32 and the lid 22. This embodiment assumes 3D formatting the lid frame prior to attaching the lid 22.

Figure 12C illustrates another type of lid alignment feature. In this type, the housing 32 is provided with at least one, preferably at least two alignment pins 112, which are configured to be fitted into respective alignment holes 113 provided in the lid 22.

For achieving best results in the manufacturing process and best yield of perfectly aligned packages of devices, any combination of the above discussed lid alignment features may also be applied.

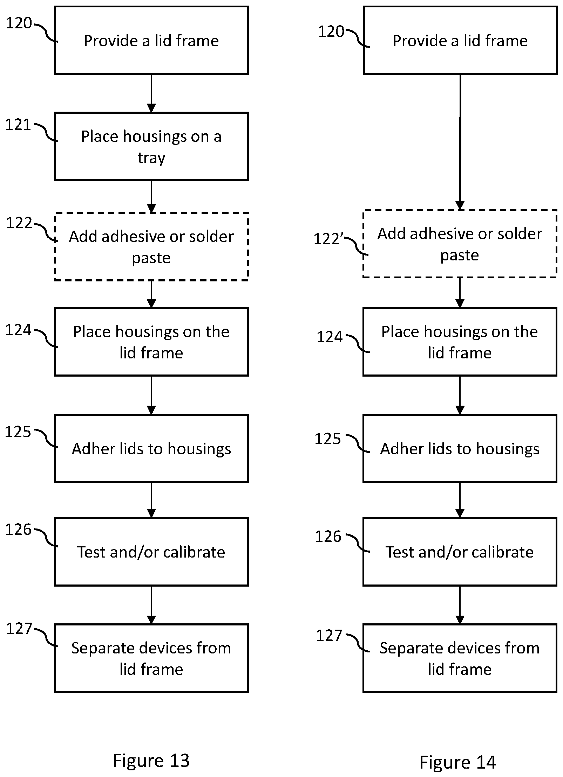

Figure 13 illustrates a first process according to some embodiments of the invention, when a tray is used to facilitate placing housings on the lid frame.

In step 120, the lid frame is provided. This step is preceded by manufacturing the lid frame i.e. by cutting it from a flat sheet of metal. The lid frame may also be pre-processed for example by pressing it to a desired shape. In particular, coupling portions and/or the lids may be bent to any desired form to facilitate alignment of the lid with the respective housing, to make room for welding tool between the frame portion of the lid frame and the lids, to form the lid into a bulging cap form to add space between the lid and the housing and so on. The lid frame comprises a plurality of lids arranged in a row at predefined intervals.

In step 121, housings are placed on a tray. Housings may be placed on the tray by a pick and place tool. The tray is designed to cause the housings to be arranged in a row at predefined intervals, corresponding to intervals of the row of lids in the lid frame. The tray preferably comprises a plurality of depressions which help in aligning the housings with the tray. Typically, longitudinal axis of the housings is aligned with longitudinal axis of the tray, but this is all dependent on design of the housings. Thus, longitudinal axis of the housings may also be arranged perpendicular to the longitudinal axis of the tray. If the housings are square, a predetermined axis of the housing is preferably aligned with the longitudinal axis of the tray. The tray may comprise a spring arrangement or a spring arrangement may be removably or permanently attached thereto. The spring arrangement facilitates desired alignment of the housings when placed on the tray.

In step 122 adhesive or solder paste is applied on the upper face of the housing, on the lid or on both the housing and the lid. As already discussed above, adhesive may be screen printed to generate a precise pattern. Other possible methods of adding adhesive are dispensing, jetting and stamping. Likewise, screen printing, dispensing, jetting or stamping may be used to generate a precise solder paste pattern. If adhesive attachment is used, the pre-applied adhesive is preferably b-staged. Purpose of the adhesive or the solder paste is to enable adhering each housing with the lid. In this step, when adhesive is used, the adhesive may be b-staged. The applied adhesive may provide means for temporary attachment between the housing and the lid before the adhesive is cured. The applied solder paste may provide means for temporary attachment between the housing and the lid before the solder joint is finalized by heating.

If attachment is performed by welding, adhesive or solder paste is not required.

The upper face of the housing may be provided with a kovar ring if one or more components of the device need to be hermetically sealed from ambient environment. Kovar refers to a nickel-cobalt ferrous alloy. Typically, the kovar ring is provided as part of the housing when received from a housing manufacturer. The kovar ring enables soldering or welding of the lid to the housing. The kovar ring is preferably used with full seam soldering or full seam welding in step 125.

In step 124, the housings that were temporarily attached to the tray are placed on the lid frame or the lid frame is placed on the housings attached to the tray, while ensuring by the lid frame that each lid is properly collocated with the respective housing. Spatial direction on which is on top, tray or the lid frame is a design option, and wording does not determine which one is on top. If the components are designed to be in controlled atmosphere between the housing and the lid, at least attachment of the housing(s) and the lid(s) is made in a controlled atmosphere. For example, the controlled atmosphere may have reduced pressure, and/or it comprise one or more inert gases.

In step 125, lids are adhered to respective housings. This adhering is intended to be substantially permanent. In the simplest case, when only adhesive is used to adher lids to housings, adhering is performed for example by subjecting a pre-applied adhesive to heat and/or UV light and/or a curing agent to cause the adhesive to cure. When adhering is implemented by soldering, solder paste is heated to complete the solder joint as known in the art. Lids may also be adhered to the housing by welding by any one of a partial seam weld, a spot welding and a full seam welding. When welding is used for attachment, adhesive and solder paste may be omitted.

In step 126, readily packaged devices are tested and/or calibrated while still attached to the lid frame. This way they can be handled with the same testing and/or calibration equipment that is used for testing and/or calibrating devices manufactured using a lead frame. Proper alignment of housings in the lead frame is important to ensure that component pad areas in the component housings matching with pin locations of the testing and/or calibrating devices.

For example, ceramic housings are typically provided with relatively large contact pads under the housing, which are relatively easy to align sufficiently well with pins of the testing and/or calibrating devices.

In step 127, readily tested and/or calibrated devices are separated from the lid frame. Separation, also referred to as singulation, may be performed by cutting the coupling portions between the lid and the frame portion of the lid frame. Separation may be performed for example by cutting, punching, and laser detachment.

Figure 14 illustrates a second process according to some embodiments of the invention when no tray is used. Steps corresponding to those of Figure 13 remain the same.

In optional step 122', adhesive or solder paste is added, preferably on the lid frame. As already discussed above, adhesive may be screen printed to generate a precise pattern. If adhesive attachment is used, the pre-applied adhesive is preferably b-staged. The b-staged adhesive facilitates temporary attachment between the housing and the lid before the adhesive is cured. The applied solder paste facilitates temporary attachment between the housing and the lid before the solder joint is finalized by heating.

In step 124, housings are placed on the lid frame using a pick and place equipment, and in step 125 lids are adhered to housings as discussed above, either by adhesive, solder or welding. If welding is used, adhesive and solder may be omitted.

Steps 126 and 127 correspond to those discussed above.

## Claims

1. A method for manufacturing a plurality of electronic and/or microelectromechanical system, MEMS, devices, the method comprising:
- providing a lid frame comprising a frame portion and a plurality of lids, wherein the plurality of lids is placed in the lid frame in a row at predefined intervals along the longitudinal dimension of the lid frame,
- placing a plurality of housings on the lid frame, each housing comprising one or more electronic and/or MEMS components and electrical connections thereof,
- adhering each of the plurality of lids to the respective housing to enclose electronic and/or MEMS components of the electronic and/or MEMS device in an enclosure formed by the housing and the lid,
- testing and/or calibrating the plurality of electronic and/or MEMS devices while adhered to the lid frame by means of an apparatus designed to perform testing and/or calibration of devices attached to a lead frame having a frame portion with dimensions similar to dimensions of the frame portion of the lid frame,
- after said testing and/or calibrating, detaching the plurality of electronic and/or MEMS devices from the lid frame by any one of: cutting, punching, and laser detachment such that each lid remains adhered to the respective housing.

2. The method according to claim 1, comprising:
- prior to placing the plurality of housings on the lid frame, placing the plurality of housings on a tray, wherein the plurality of housings is placed on a plurality of depressions of the tray, wherein the plurality of depressions is arranged into a row along the longitudinal dimension of the tray at the same predefined intervals as the plurality of lids in the lid frame,
- placing the plurality of housings on the lid frame by placing the lid frame on the plurality of housings placed on the tray, thereby covering each one of the plurality housings by a collocated one of the plurality of lids before said adhering each one of the plurality of lids to the respective housing.

3. The method according to claim 2, wherein the step of placing the plurality of housing on the tray further comprises:
- forcing each housing to be aligned with a respective tray wall by means of at least one spring arrangement comprised in or attached to the tray.

4. The method according to claim 1, comprising:
- placing the plurality of housings on the lid frame by means of a pick and place equipment prior to adhering the respective housing to the respective one of the plurality of lids.

5. The method according to any one of the preceding claims, wherein the method comprises:
- providing each of the lids of the lead frame and/or the housing with at least one lid alignment feature, wherein the at least one lid alignment feature is configured to facilitate correct alignment between the housing and the respective lid, and
- guiding each housing to a correct position with respect to the respective lid in the lead frame by means of the at respective least one lid alignment feature.

6. The method according to claim 5, wherein the lid alignment feature comprises at least two bent edges of the lid, and the method comprises:
- prior to placing the plurality of housings on the lid frame, bending at least some edges of the plurality of lids to facilitate alignment of the housing with the respective lid.

7. The method according to claim 5 or 6, wherein the lid alignment feature comprises one or more of the following: a depression in the housing and a matching shape of the lid, a depression in the housing and a matching coupling portion of the lid frame, a hole in the lid frame and a matching pin in the housing.

8. The method according to any one of the preceding claims, comprising:
- attaching the lid to the respective housing by any one of: an adhesive, a partial seam weld, spot welding, full seam welding, and full seam soldering.

9. The method according to claim 8, wherein the method comprises attaching the lid to the housing using full seam welding, and wherein the method comprises:
- prior to placing the plurality of housings on the lid frame, bending a plurality of coupling portions of the lid frame coupling the plurality of lids to the frame portion of the lid frame, to cause an offset between a plane defined by the plurality of lids and a plane defined by the frame portion, and
- performing the full seam welding between each one of the plurality of housings and the respective lid by means of wheel electrodes.

10. The method according to claim 8 or 9, wherein the upper face of each of the plurality of housings is provided with a kovar ring to facilitate hermetic sealing between the housing and the respective lid, and wherein the method comprises:
- attaching the lid to the housing using full seam soldering or full seam welding.

11. The method according to any one of the preceding claims, wherein the method further comprises, prior to placing the plurality of housings on the lid frame, applying one of an adhesive and a solder on each lid of the lid frame and/or on the upper face of the housing.

12. A lid frame comprising a frame portion and plurality of lids arranged in a row at predefined intervals along the longitudinal dimension of the lid frame, wherein the lid frame is configured to be used in the method according to any one of claims 1 to 11.

13. A device testing and/or calibration equipment configured to test and/or calibrate MEMS and/or electronic devices attached to a lid frame according to claim 12.

14. An elongated tray comprising a plurality of depressions arranged into a row along the longitudinal dimension of the elongated tray at the same predefined intervals as the plurality of lids in the lid frame, wherein each of the plurality of depressions is configured to receive a housing comprising one or more electronic and/or MEMS components and electrical connections thereof, wherein the elongated tray is configured to be used in the method according to any one of claims 1 to 3, or any one of claims 5 to 11 when dependent on any one of claims 1 to 3.
